# EUROPÄISCHE PATENTSCHRIFT

(11) **EP 3 143 778 B1**
(45) Veröffentlichungstag und Bekanntmachung des Hinweises auf die Patenterteilung: **16.06.2021**
(21) Anmeldenummer: 15723691.0
(22) Anmeldetag: 13.05.2015
(51) Int. Cl.: H04R 19/02, H04R 17/00, H04R 17/02, H04R 19/04

(54) **MEMS-SCHALLWANDLER SOWIE SCHALLWANDLERANORDNUNG MIT STOPPER-MECHANISMUS**
MEMS ACOUSTIC TRANSDUCER, AND ACOUSTIC TRANSDUCER ASSEMBLY HAVING A STOPPER MECHANISM
TRANSDUCTEUR ACOUSTIQUE MEMS AINSI QUE SYSTÈME DE TRANSDUCTEUR ACOUSTIQUE ÉQUIPÉ D'UN MÉCANISME D'ARRÊT

(30) Priorität: 14.05.2014 DE 102014106753
(43) Veröffentlichungstag der Anmeldung: 22.03.2017
(73) Patentinhaber: USound GmbH, 8020 Graz (AT)
(72) Erfinder: RUSCONI CLERICI BELTRAMI, Andrea, 1130 Wien (AT); BOTTONI, Ferruccio, 8020 Graz (AT)
(74) Vertreter: Canzler & Bergmeier Patentanwälte Partnerschaft mbB
(86) Internationale Anmeldenummer: PCT/EP2015/060658
(87) Internationale Veröffentlichungsnummer: WO 2015/173333

(56) Entgegenhaltungen:
- DE-A1-102012 200 957
- JP-A- 2008 030 182
- US-A1- 2009 015 108

## Beschreibung

Die vorliegende Erfindung betrifft einen MEMS-Schallwandler zum Erzeugen und/oder Erfassen von Schallwellen im hörbaren Wellenlängenspektrum sowie eine Schallwandleranordnung mit einem solchen MEMS-Schallwandler. Derartige Schallwandleranordnungen können sehr klein dimensioniert sein und werden deshalb zum Beispiel in Hörgeräten, In-Ohr-Kopfhörern, Mobiltelefonen, Tablet-Computern und anderen elektronischen Geräten, die nur wenig Bauraum bieten, als Lautsprecher und/oder Mikrofon verbaut.

Die Bezeichnung MEMS steht für mikroelektromechanische Systeme. Ein MEMS-Schallwandler zur Schallerzeugung bzw. ein MEMS-Lautsprecher ist beispielsweise aus der DE 10 2012 220 819 A1 bekannt. Die Schallerzeugung erfolgt über eine schwingbar gelagerte Membran des MEMS-Lautsprechers. Derartige Schallwandleranordnungen sind gemäß den akustischen und sonstigen Anforderungen des jeweiligen Anwendungsbereichs spezifisch aufgebaut und bestehen aus einer Vielzahl unterschiedlicher Elemente.

Ein MEMS-Schallwandler zum Erfassen von Schallwellen bzw. ein MEMS-Mikrofon ist aus der WO 2015/017979 A1 bekannt. Dieser MEMS-Schallwandler zeichnet sich durch einen Stopper-Mechanismus aus, der die empfindliche Membran vor Beschädigungen schützt, die zum Beispiel durch zu große Bewegungen der Membran aufgrund von Schalldruck oder Stößen entstehen könnten. Nachteilig ist jedoch der komplexe und nur aufwendig herzustellende Aufbau dieses Stopper-Mechanismus, welcher eine Platte mit Löchern und T-förmige Stopper-Elemente umfasst. Die Platte ist beabstandet zur Membran angeordnet und weist mehrere Löcher auf, durch die sich die Stopper-Elemente mit ihren unteren freien Enden erstrecken. Mit dem jeweils anderen Ende sind die Stopper-Elemente an der Membran befestigt.

Aus der JP 2008 030182 A ist eine MEMS-Vorrichtung bekannt, die eine Mikrostruktur mit einer beweglichen Elektrodenanordnung zum Messen der Kapazität zwischen einem Objekt und sich selbst umfasst. Die MEMS-Vorrichtung umfasst einen Mikro-Aktor mit piezoelektrischen Mikro-Kragarmen, einen Verbindungsabschnitt, der aus Scharnieren besteht und die Mikrostruktur und den Mikro-Aktor frei schwingend verbindet. Ferner umfasst die MEMS-Vorrichtung Stopper, die mit der Mikrostruktur in Kontakt stehen und deren Amplitude steuern, wenn sie von dem Mikro-Aktor in Vibration versetzt wird.

Aus der US 2009/015108 A1 ist ein piezoelektrischer elektroakustischer Wandler bekannt, der eine im Wesentlichen rechteckige piezoelektrische Membran, ein Gehäuse mit Stützen zum Tragen der vier Ecken der Unterseite der piezoelektrischen Membran, und einen Empfänger, der an einer Bodenwand des Gehäuses vorgesehen ist, umfasst. Der Empfänger begrenzt die Schwingungsamplitude der piezoelektrischen Membran auf einen vorbestimmten Bereich.

Aufgabe der vorliegenden Erfindung ist es, einen MEMS-Schallwandler mit einem verbesserten Stopper-Mechanismus zu schaffen, der einfach aufgebaut und herstellbar ist.

Die Aufgabe wird gelöst durch einen MEMS-Schallwandler sowie durch eine Schallwandleranordnung mit den Merkmalen der unabhängigen Patentansprüche.

Vorgeschlagen wird ein MEMS-Schallwandler zum Erzeugen und/oder Erfassen von Schallwellen im hörbaren Wellenlängenspektrum mit einem Membranträger, einer Membran und einem Stopper-Mechanismus. Die Membran ist in ihrem Randbereich mit dem Membranträger verbunden und vermag gegenüber dem Membranträger entlang einer im Wesentlichen zu der Membran (30) verlaufenden z-Achse (50) zu schwingen. Der Stopper-Mechanismus ist ausgebildet die Schwingungen der Membran in zumindest einer Richtung zu begrenzen. Der Stopper-Mechanismus umfasst zumindest ein Verstärkungselement, das an einer Seite der Membran angeordnet ist. Des Weiteren umfasst der Stopper-Mechanismus einen dem Verstärkungselement gegenüberliegenden Anschlag, der in einer Neutralstellung der Membran von dieser beabstandet ist und gegen den das Verstärkungselement bei maximaler Auslenkung anstößt.

Ferner wird eine Schallwandleranordnung vorgeschlagen, die einen solchen erfindungsgemäßen MEMS-Schallwandler umfasst.

Sowohl der vorgeschlagene MEMS-Schallwandler als auch die vorgeschlagene Schallwandleranordnung bieten gegenüber dem Stand der Technik viele Vorteile. Vor allem wird ein Stopper-Mechanismus bereitgestellt, der einfach aufgebaut und somit einfach und kostengünstig herstellbar ist. Dabei brauchen insbesondere keine T-förmigen Stopper-Elemente durch Löcher in einer Platte geführt und mit der Membran verbunden zu werden. Vielmehr ist die Membran mit einem Verstärkungselement ausgebildet, das mit einem gegenüberliegenden Anschlag zusammenwirkt. Somit ist die empfindliche Membran durch den erfindungsgemäßen Stopper-Mechanismus vor Beschädigungen durch zu große Bewegungen der Membran aufgrund von zu hohem Schalldruck oder äußeren Erschütterungen oder Stößen geschützt.

Der MEMS-Schallwandler umfasst einen MEMS-Aktuator, der ein Trägersubstrat besitzt, und der mit der Membran zusammenwirkt, um elektrische Signale in akustisch wahrnehmbare Schallwellen zu wandeln. Ebenso können natürlich auch akustisch wahrnehmbare Schallwellen in elektrische Signale gewandelt werden. Das Trägersubstrat ist vorzugsweise aus Silizium hergestellt.

Der Anschlag ist zumindest teilweise an dem Trägersubstrat des MEMS-Aktuators ausgebildet. Somit sind zur Ausbildung des Anschlags vorteilhafterweise keine zusätzlichen Bauteile erforderlich. Alternativ oder ergänzend ist das Verstärkungselement an einer dem MEMS-Aktuator zugewandten Seite an der Membran befestigt. Hierdurch ist die Membran beim Anschlagen gegen den Anschlag mittels des Verstärkungselementes geschützt.

Vorteilhafterweise ist die der Membran zugewandte Stirnseite des Trägersubstrates des MEMS-Aktuators als Anschlag ausgebildet. Zusätzlich oder alternativ ist es vorteilhaft, wenn der MEMS-Aktuator, insbesondere an einer der Membran abgewandten Seite des Trägersubstrates, eine Aktuatorstruktur aufweist. Die Aktuatorstruktur ist vorzugsweise aus einer piezoelektrischen Schicht ausgebildet.

In einer vorteilhaften Weiterbildung der Erfindung ist der Randbereich der Membran in einem vom MEMS-Aktuator, insbesondere vom Trägersubstrat, vorzugsweise in x-, y- und/oder z-Richtung, beabstandeten Befestigungsbereich des Membranträgers befestigt. Durch diese Entkopplung der Membranaufhängung vom Trägersubstrat, kann die akustisch wirksame Fläche der Membran größer als das Trägersubstrat ausgebildet werden.

In einer weiteren vorteilhaften Ausbildung der Erfindung bilden zumindest ein Gehäuseteil und/oder eine Leiterplatte den Membranträger, wobei die Membran vorzugsweise zwischen zwei dieser Bauteile befestigt ist.

Vorteilhaft ist es, wenn die Membran einen, insbesondere als Wulst ausgebildeten, äußeren elastischen Bereich aufweist. Dieser ist vorzugsweise benachbart zum Randbereich angeordnet. Alternativ oder ergänzend weist die Membran einen inneren verstärkten Bereich auf, in dem das Verstärkungselement angeordnet ist. Der elastische Bereich erlaubt der Membran gegenüber dem Membranträger zu schwingen. So kann der innere verstärkte Bereich der Membran mit dem Verstärkungselement gegenüber dem äußeren Randbereich der Membran und/oder ihrem Befestigungsbereich schwingen.

Auch ist es vorteilhaft, wenn der verstärkte Bereich und/oder das Verstärkungselement, insbesondere unmittelbar, benachbart zu dem elastischen Bereich angeordnet sind.

In einer vorteilhaften Weiterbildung der Erfindung kann das Verstärkungselement aus einem Kunststoff, einem Metall und/oder einem Faserverbundwerkstoff ausgebildet sein. Auch ist es vorteilhaft, wenn das Verstärkungselement plattenförmig ausgebildet ist, mit der, insbesondere aus Silikon bestehenden, Membran verklebt ist und/oder sich über den gesamten verstärkten Bereich erstreckt. In ihrem verstärkten Bereich bzw. durch das Verstärkungselement besitzt die Membran eine erhöhte Steifigkeit und somit bessere akustische Eigenschaften insbesondere mit Blick auf die erreichbare Lautstärke, den Frequenzumfang und/oder die Signaltreue.

In einer weiteren vorteilhaften Ausbildung der Erfindung weist das Verstärkungselement eine mit dem Anschlag korrespondierende Anschlagsfläche auf. Die Anschlagsfläche ist vorzugsweise als geschlossener Rahmen ausgebildet.

Bevorzugt ist vorgesehen, dass das Verstärkungselement eine Koppelfläche aufweist, die vorzugsweise im Inneren der rahmenförmigen Anschlagsfläche angeordnet ist und/oder in deren Bereich das Verstärkungselement mit der Aktuatorstruktur, insbesondere mittelbar über ein Koppelelement, verbunden ist.

Ferner ist es vorteilhaft, wenn die Anschlagsfläche und die Koppelfläche in z-Richtung voneinander beabstandet sind und/oder über einen, insbesondere trichterförmigen, Zwischenbereich des Verstärkungselementes miteinander verbunden sind. Hierdurch vergrößert sich vorteilhafterweise die Gesamtfläche der Membran, ohne dass die Membran einen größeren Durchmesser aufweist, wodurch - bei gleichzeitiger Verbesserung der akustischen Eigenschaften der Membran - Bauraum und Material eingespart werden können.

Gemäß einer weiteren bevorzugten Ausbildung der Erfindung sind das Trägersubstrat und das Koppelelement aus dem gleichen Substrat, insbesondere einem Siliziumsubstrat, hergestellt und weisen insbesondere die gleiche Dicke auf.

In einer vorteilhaften Weiterbildung der Erfindung umfasst der Stopper-Mechanismus einen zweiten Anschlag, der die Schwingungen der Membran entlang der z-Achse in einer zur ersten Richtung entgegengesetzten zweiten Richtung begrenzt, wobei der zweite Anschlag vorzugsweise in einem durch ein Gehäuseteil ausgebildeten Schallleitkanal angeordnet ist. Durch den zweiten Anschlag, welcher in entgegengesetzter Richtung zum ersten Anschlag wirkt, wird die Membran noch besser vor Beschädigungen geschützt.

Bevorzugt ist ferner vorgesehen, dass die beiden Anschläge zueinander gegenüberliegend angeordnet sind und/oder das Verstärkungselement zwischen diesen beiden Anschlägen und von diesen beabstandet angeordnet ist.

Die Schallwandleranordnung umfasst in einer vorteilhaften Weiterbildung der Erfindung neben einem MEMS-Schallwandler auch eine Leiterplatte, die einen vollständig eingebetteten ASIC und/oder eine sich durch die Leiterplatte erstreckende Aussparung aufweist, wobei vorzugsweise an einer ersten Öffnung der Aussparung ein MEMS-Aktuator und/oder an einer zweiten Öffnung der Aussparung zur Ausbildung einer geschlossenen Kavität ein Gehäuseteil angeordnet sind.

Weitere Vorteile der Erfindung sind in den nachfolgenden Ausführungsbeispielen beschrieben. Es zeigt:
- **Figur 1**: ein erstes Ausführungsbeispiel der Schallwandleranordnung und des MEMS-Schallwandlers in einer perspektivischen Schnittansicht,
- **Figur 2**: das erste Ausführungsbeispiel der Schallwandleranordnung und des MEMS-Schallwandlers in einer schematischen seitlichen Schnittansicht,
- **Figur 3**: das erste Ausführungsbeispiel der Schallwandleranordnung und des MEMS-Schallwandlers mit einer in eine erste Richtung ausgeschwungenen Membran in einer schematischen seitlichen Schnittansicht,
- **Figur 4**: das erste Ausführungsbeispiel der Schallwandleranordnung und des MEMS-Schallwandlers mit einer in eine zweite Richtung ausgeschwungenen Membran in einer schematischen seitlichen Schnittansicht,
- **Figur 5**: ein zweites Ausführungsbeispiel der Schallwandleranordnung und des MEMS-Schallwandlers in einer perspektivischen Schnittansicht,
- **Figur 6**: das zweite Ausführungsbeispiel der Schallwandleranordnung und des MEMS-Schallwandlers in einer schematischen seitlichen Schnittansicht und
- **Figur 7**: ein drittes Ausführungsbeispiel der Schallwandleranordnung und des MEMS-Schallwandlers in einer schematischen seitlichen Schnittansicht.

Bei der nachfolgenden Figurenbeschreibung werden, um die Beziehungen zwischen den verschiedenen Elementen zu definieren, bezugnehmend auf die jeweils in den Figuren dargestellte Lage der Objekte relative Begriffe, wie beispielsweise oberhalb, unterhalb, oben, unten, drüber, drunter, links, rechts, vertikal und horizontal, verwendet. Es versteht sich von selbst, dass sich diese Begrifflichkeiten bei einer Abweichung von der in den Figuren dargestellten Lage der Vorrichtungen und/oder Elemente verändern können. Demnach würde beispielsweise bei einer in Bezug auf die Figuren dargestellten invertierten Orientierung der Vorrichtungen und/oder Elemente ein in der nachfolgenden Figurenbeschreibung als oberhalb spezifiziertes Merkmal nunmehr unterhalb angeordnet sein. Die verwendeten Relativbegriffe dienen somit lediglich zur einfacheren Beschreibung der relativen Beziehungen zwischen den einzelnen im nachfolgenden beschriebenen Vorrichtungen und/oder Elemente.

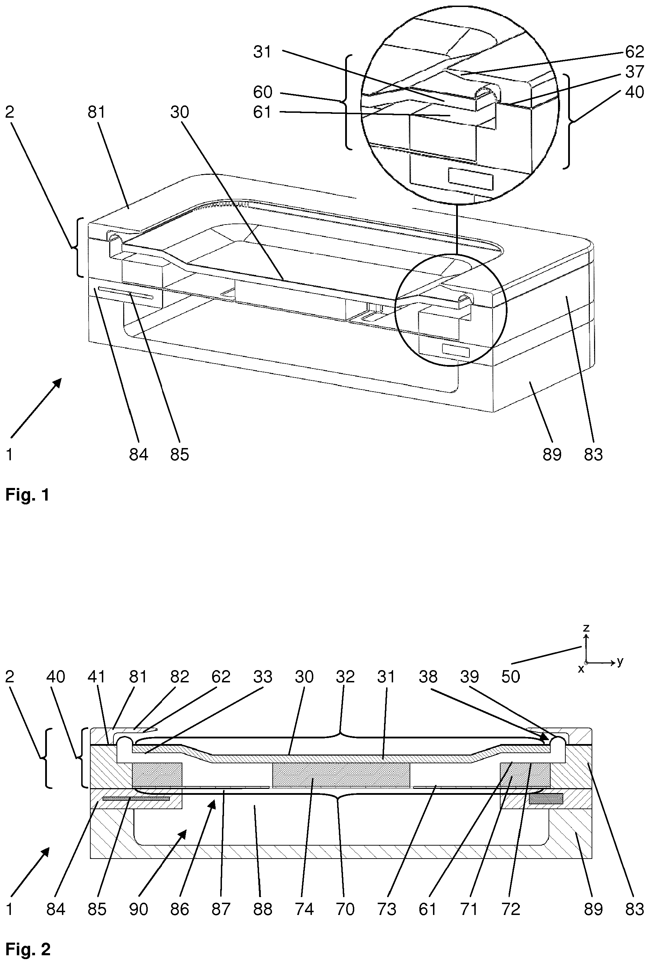

Die Figuren 1 bis 4 zeigen ein erstes Ausführungsbeispiel einer Schallwandleranordnung 1 mit einem MEMS-Schallwandler 2 in verschiedenen Ansichten. Der MEMS-Schallwandler 2 ist ausgebildet zum Erzeugen und/oder Erfassen von Schallwellen im hörbaren Wellenlängenspektrum. Hierzu besitzt er eine Membran 30 und einen Membranträger 40. Die Membran 30 ist in ihrem Randbereich 37 mit dem Membranträger 40 verbunden und vermag gegenüber dem Membranträger 40 entlang einer z-Achse 50 zu schwingen. Die z-Achse 50 verläuft dabei im Wesentlichen senkrecht zu der Membran 30.

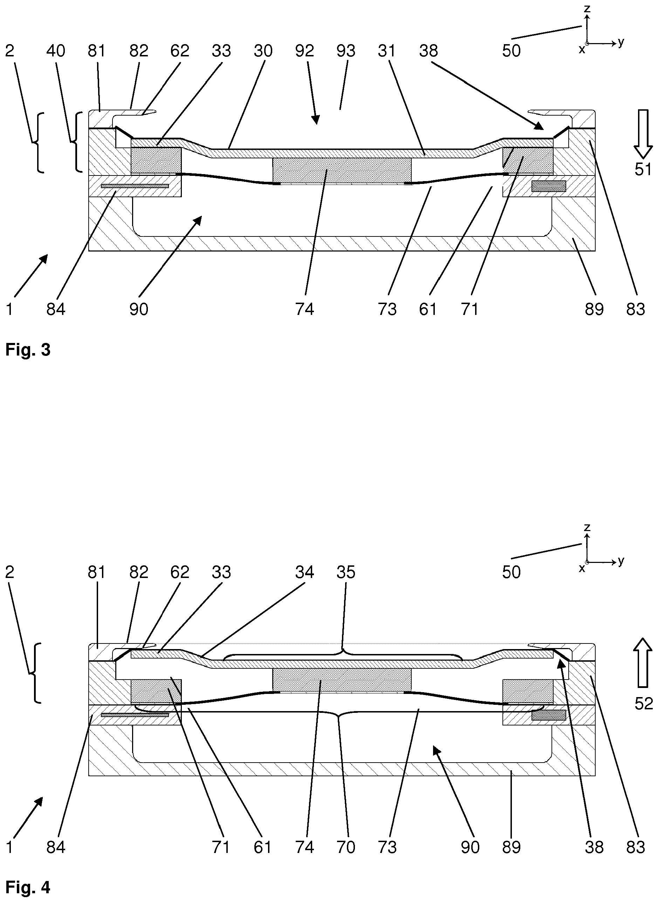

Der MEMS-Schallwandler 2 weist außerdem einen Stopper-Mechanismus 60 auf, der ausgebildet ist, die Schwingungen der Membran 30 in zumindest einer Richtung 51 zu begrenzen. Hierzu weist der Stopper-Mechanismus 60 ein Verstärkungselement 31 auf, das an einer Seite der Membran 30, hier an deren Unterseite, angeordnet ist. Zum Anderen weist der Stopper-Mechanismus 60 einen dem Verstärkungselement 31 gegenüberliegenden Anschlag 61 auf, der in einer Neutralstellung der Membran 30, wie in den Figuren 1 und 2 gezeigt, von der Membran 30 beabstandet ist und gegen den das Verstärkungselement 31 bei maximaler Auslenkung der Membran 30 in die Richtung 51, wie in der Figur 3 gezeigt, anstößt.

In diesem Beispiel umfasst der Stopper-Mechanismus 60 noch einen zweiten Anschlag 62, der die Schwingungen der Membran 30 entlang der z-Achse 50 in einer zur ersten Richtung 51 entgegengesetzten zweiten Richtung 52 begrenzt. Auch der zweite Anschlag 62 ist in einer Neutralstellung der Membran 30, wie in den Figuren 1 und 2 gezeigt, von der Membran 30 beabstandet, wobei das Verstärkungselement 31 bei maximaler Auslenkung der Membran 30 in die zweite Richtung 52, wie in der Figur 4 gezeigt, gegen den zweiten Anschlag 62 anstößt. In diesem Fall liegt die Membran 30 zwischen dem zweiten Anschlag 62 und dem Verstärkungselement 31.

Infolgedessen ist die Membran 30 gemäß Figur 3 soweit nach unten ausgeschwungen bzw. ausgelenkt, dass das Verstärkungselement 31 an den ersten Anschlag 61 anstößt, während die Membran 30 gemäß Figur 4 soweit nach oben ausgeschwungen bzw. ausgelenkt ist, dass das Verstärkungselement 31 an den zweiten Anschlag 62 des Stopper-Mechanismus 60 anstößt.

Wie insbesondere aus den Figuren 1 bis 4 ferner ersichtlich ist, sind die beiden Anschläge 61, 62 zueinander gegenüberliegend angeordnet, wobei das Verstärkungselement 31 zwischen diesen beiden Anschlägen und von diesen beabstandet angeordnet ist. Der zweite Anschlag 62 ist dabei an einem oberen Gehäuseteil 81, welches oberhalb der Membran 30 angeordnet ist, und insbesondere in einem durch das obere Gehäuseteil 81 gebildeten Schallleitkanal 92 angeordnet.

Der erste Anschlag 61 ist hingegen an einem Trägersubstrat 71 eines MEMS-Aktuators 70 angeordnet bzw. durch eine Seite des Trägersubstrates 71 ausgebildet. Dieser MEMS-Aktuator 70 ist unterhalb der Membran 30 und/oder im Wesentlichen parallel zu dieser angeordnet. Er wirkt mit der Membran 30 zusammen, um elektrische Signale in akustisch wahrnehmbare Schallwellen zu wandeln oder umgekehrt. Hierzu umfasst der MEMS-Aktuator 70 eine Aktuatorstruktur 73. Diese ist vorzugsweise piezoelektrisch ausgebildet. Des Weiteren ist die Aktuatorstruktur 73 an einer der Membran 30 abgewandten Seite des Trägersubstrates 71 angeordnet. In diesem Beispiel ist die der Membran 30 zugewandte Stirnseite 72 des Trägersubstrates 71 des MEMS-Aktuators 70 als Anschlag 61 ausgebildet. Anders als hier gezeigt könnte der erste Anschlag 61 aber auch an einem Gehäuseteil wie dem mittleren Gehäuseteil 83 und/oder an einer Leiterplatte wie der Leiterplatte 84 ausgebildet sein. Das Verstärkungselement 31 ist vorliegend an der dem MEMS-Aktuator 70 zugewandten Seite an der Membran 30 befestigt. Zusätzlich oder alternativ könnte das Verstärkungselement 31 oder aber auch ein zusätzliches Verstärkungselement grundsätzlich auch an der dem MEMS-Aktuator 70 abgewandten Seite an der Membran 30 befestigt sein. Insbesondere weist das Verstärkungselement 31 eine mit den Anschlägen 61, 62 korrespondierende Anschlagsfläche 33 auf.

Die Schallwandleranordnung 1 umfasst neben der Membran 30, dem Membranträger 40, dem MEMS-Aktuator 70 und den beiden Gehäuseteilen 81, 83 des MEMS-Schallwandlers 2 auch noch eine Leiterplatte 84 sowie ein unteres Gehäuseteil 89. In die Leiterplatte 84 ist ein ASIC 85 vollständig eingebettet. Zusätzlich zu dem ASIC können auch weitere passive Komponenten, wie elektrische Widerstände und/oder E/A-Kontakte, in die Leiterplatte eingebettet und/oder an dieser angeordnet sein.

Die Leiterplatte 84 weist eine Aussparung 86 auf, die sich vollständig durch die Leiterplatte erstreckt und zwei Öffnungen 87, 88 besitzt. An der ersten Öffnung 87 der Aussparung 86 ist der MEMS-Aktuator 70 angeordnet. An der zweiten Öffnung 88 der Aussparung 86 ist zur Ausbildung einer geschlossenen Kavität das untere Gehäuseteil 89 angeordnet. Somit ist die Leiterplatte 84 zwischen MEMS-Aktuator 70 und dem unteren Gehäuseteil 89 angeordnet.

Der MEMS-Schallwandler 2 und insbesondere der MEMS-Aktuator 70 ist mit in den Figuren nicht weiter dargestellten elektrischen Kontakten mit dem ASIC 85 verbunden. Der MEMS-Schallwandler 2 kann somit über den ASIC 85 angesteuert bzw. betrieben werden. Wenn der MEMS-Schallwandler 2 zum Beispiel als Lautsprecher fungieren soll, kann er über den ASIC 85 derart angeregt werden, dass durch den MEMS-Aktuator 70 die Membran 30 zur Erzeugung von Schallenergie gegenüber dem Membranträger 40 in Schwingung versetzt wird. Unter der Begrifflichkeit "Kavität" ist ein Hohlraum zu verstehen, mittels dem der Schalldruck des MEMS-Schallwandlers verstärkt werden kann. Da die Kavität teilweise bereits durch die Aussparung 86 der Leiterplatte 84 gebildet wird, kann die Schallwandleranordnung 1 sehr bauraumsparend mit einem dennoch relativ großen akustisch wirksamen Kavitätsvolumen ausgebildet werden, da der durch das untere Gehäuseteil 89 zur Bildung der Kavität bereitgestellte Hohlraum nunmehr kleiner ausfallen kann. Die Gehäuseteile 81, 83 und insbesondere das untere Gehäuseteil 89 weisen vorzugsweise ein zur Leiterplatte 84 unterschiedliches Material auf. Alternativ könnte aber auch zumindest eines der Gehäuseteile 81 Bestandteil der Leiterplatte 84 sein.

Die Schallwandleranordnung 1 hat eine im Wesentlichen rechteckige Grundform und ist somit einfach und kostengünstig herstellbar und für zahlreiche Anwendungszwecke geeignet. Die Schallwandleranordnung 1 ist zudem sandwichartig aufgebaut, das heißt, dass das untere Gehäuseteil 89, die Leiterplatte 84 und der MEMS-Schallwandler 2 aufeinandergestapelt angeordnet sind. Der MEMS-Schallwandler 2, die Leiterplatte 84 und das untere Gehäuseteil 89 haben dabei alle denselben Außendurchmesser. Alternativ kann die Schallwandleranordnung 1 aber grundsätzlich auch eine andere, insbesondere eine runde, Grundform aufweisen.

Die Membran 30, welche insbesondere aus Silikon besteht, ist in ihrem Randbereich 37 in dem Befestigungsbereich 41 des Membranträgers 40 befestigt, wobei der Befestigungsbereich 41 in x-, y- und z-Richtung von dem MEMS-Aktuator 70 und dessen Trägersubstrat 71 beabstandet angeordnet ist. Der Membranträger 40 wird hier von dem oberen Gehäuseteil 81 und dem mittleren Gehäuseteil 83 gebildet, wobei der Befestigungsbereich zwischen den beiden Gehäuseteilen 81, 83 liegt und somit die Membran zwischen diesen beiden Gehäuseteilen befestigt ist. Der Membranträger 40 ist rahmenartig ausgebildet und umgibt die Membran 30. Anders als hier gezeigt könnte der Membranträger 40 aber auch zumindest teilweise durch eine Leiterplatte wie die Leiterplatte 84 gebildet werden.

Benachbart zu ihrem Randbereich 37 weist die Membran 30 einen vorliegende insbesondere als Wulst 39 ausgebildeten, äußeren elastischen Bereich 38 und einen inneren verstärkten Bereich 32, in dem das Verstärkungselement 31 angeordnet ist, auf. Dabei ist der verstärkte Bereich 32 bzw. das Verstärkungselement 31 unmittelbar benachbart zu dem elastischen Bereich 38 angeordnet. Der elastische Bereich 38 erlaubt der Membran 30 gegenüber dem Membranträger 40 und insbesondere dem innere verstärkten Bereich 32 gegenüber dem äußeren Randbereich 37 zu schwingen. Das Verstärkungselement 31 ist hier aus einem Metall und/oder plattenförmig ausgebildet, wobei es sich wie vorliegende vorzugsweise über den gesamten verstärkten Bereich 32 erstreckt und mit der Membran 30 verklebt ist. Die durch das Verstärkungselement bereitgestellte und mit den Anschlägen 61, 62 korrespondierende Anschlagsfläche 33 ist hier rahmenartig ausgebildet und unmittelbar benachbart zu dem ebenfalls rahmenartig ausgebildeten elastischen Bereich 38 angeordnet.

Auch der erster Anschlag 61 und der zweite Anschlag 62 sind in diesem Beispiel korrespondierend zur Anschlagsfläche 33 rahmenartig ausgebildet. Dabei umgibt das Trägersubstrat 71, das an seiner Stirnseite 72 den ersten Anschlag 61 bereitstellt, rahmenartig die Aktuatorstruktur 73, während das obere Gehäuseteil 81 einen Vorsprung 82 aufweist, welcher rahmenartig die akustische Ein-/Austrittsöffnung 93 des Schallleitkanals 92 umgibt und den zweiten Anschlag 62 bereitstellt.

Im Inneren der rahmenförmigen Anschlagsfläche 33 weist das Verstärkungselement 31 der Membran 30 eine Koppelfläche 35 auf. Die Anschlagsfläche 33 und die Koppelfläche 35 sind dabei in z-Richtung voneinander beabstandet und über einen Zwischenbereich 34 des Verstärkungselementes 31, welcher hier trichterförmig ausgebildet ist, miteinander verbunden. Da das Verstärkungselement 31 mit der Membran 30 verklebt ist, weist demzufolge auch die Membran 30 eine trichterartige Form auf. Im Bereich der Koppelfläche 35 ist das Verstärkungselement 31 mit der Aktuatorstruktur 73 des MEMS-Aktuators 70 über ein Koppelelement 74 verbunden. Vorliegend ist das Trägersubstrat 71 und das Koppelelement 74 aus dem gleichen Substrat, insbesondere einem Siliziumsubstrat, hergestellt. Sie weisen ferner infolgedessen die gleiche Dicke auf. Anders als hier dargestellt, kann alternativ oder ergänzend zu dem Koppelelement 74 ein Adapterelement zur Verbindung mit der Aktuatorstruktur 73 eingesetzt werden.

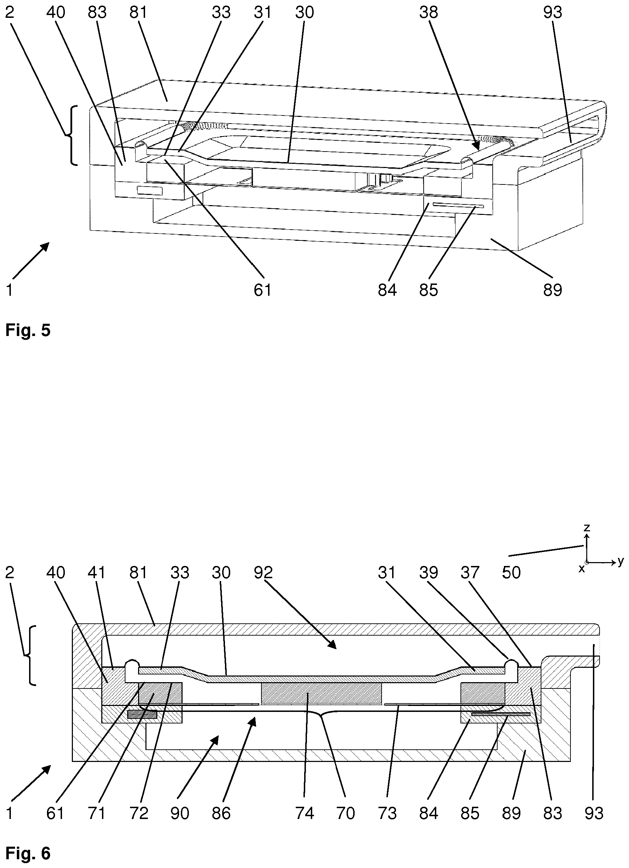

In den Figuren 5 bis 7 sind weitere Ausführungsbeispiele der Schallwandleranordnung 1 und des MEMS-Schallwandlers 2 gezeigt, wobei jeweils im Wesentlichen auf die Unterschiede in Bezug auf das bereits beschriebene erste Ausführungsbeispiel eingegangen wird. So werden bei den Figuren 5 bis 7 und der nachfolgenden Beschreibung der weiteren Ausführungsbeispiele für Merkmale, die im Vergleich zum in den Figuren 1 bis 4 dargestellten ersten Ausführungsbeispiel in ihrer Ausgestaltung und/oder Wirkweise identisch und/oder zumindest vergleichbar sind, gleiche Bezugszeichen verwendet. Sofern diese Merkmale nicht nochmals detailliert erläutert werden, entspricht deren Ausgestaltung und Wirkweise den vorstehend bereits beschriebenen Merkmalen. Die nachfolgend beschriebenen Unterschiede können mit den Merkmalen der jeweils vorstehenden und nachfolgenden Ausführungsbeispiele kombiniert werden.

Die Figuren 5 und 6 zeigen ein zweites Ausführungsbeispiel der Schallwandleranordnung 1 und des MEMS-Schallwandlers 2 in verschiedenen Ansichten. Als wesentlicher Unterschied gegenüber dem in den Figuren 1 bis 4 dargestellten ersten Ausführungsbeispiel ist bei dem zweiten Ausführungsbeispiel das obere Gehäuseteil 81 zu nennen. Das obere Gehäuseteil 81 bildet hier einen Schallleitkanal 92 mit einer akustischen Ein-/Austrittsöffnung 93 aus, die seitlich an der Außenfläche des MEMS-Schallwandlers 2 bzw. der Schallwandleranordnung 1 angeordnet ist. Das Gehäuseteil 81 bietet insbesondere einen zusätzlichen Schutz für die Membran 30, da es diese gegenüber der Umgebung abdeckt.

Allerdings ist bei diesem Ausführungsbeispiel kein zweiter Anschlag vorgesehen, das heißt an dem oberen Gehäuseteil 81 ist kein Anschlag für das Verstärkungselement 31 der Membran 30 angeordnet. Ferner ist das obere Gehäuseteil 81 hier nicht Bestandteil des Membranträgers 40. Dieser wird allein durch das mittlere Gehäuseteil 83 gebildet, so dass die Membran 30 allein an dem mittleren Gehäuseteil 83 befestigt ist. Das obere sowie das untere Gehäuseteil 81, 89 weisen gegenüber dem ersten Ausführungsbeispiel einen größeren Außendurchmesser auf, wodurch die Grundfläche der Schallwandleranordnung 1 vergrößert ist. Zudem ist das obere Gehäuseteil 81 in diesem Beispiel nicht auf dem mittleren Gehäuseteil 83, sondern auf dem unteren Gehäuseteil 89 angeordnet und mit diesem verbunden, so dass diese beiden Gehäuseteile zusammen ein Gehäuse bilden, das die übrigen Bauteile der Schallwandleranordnung 1 bzw. des MEMS-Schallwandlers 2 schützend umgibt.

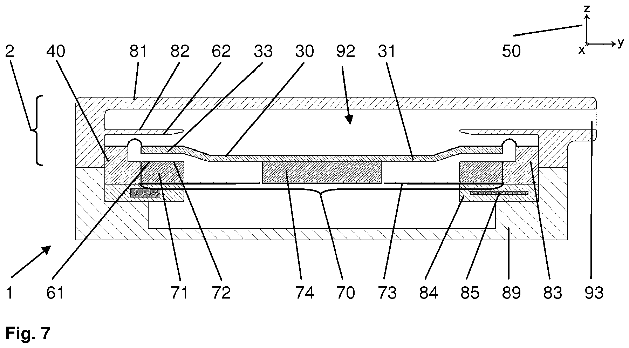

Figur 7 zeigt ein drittes Ausführungsbeispiel der Schallwandleranordnung 1 und des MEMS-Schallwandlers 2. Bei diesem weist das obere Gehäuseteil 81 innerhalb des Schallleitkanals 92 einen Vorsprung 82 auf, welcher oberhalb der Membran 30 angeordnet ist und den zweiten Anschlag 62 das Verstärkungselement 31 der Membran 30 bildet.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Schallwandleranordnung
- 2: MEMS-Schallwandler

- 30: Membran
- 31: Verstärkungselement
- 32: verstärkten Bereich
- 33: Anschlagsfläche
- 34: Zwischenbereich
- 35: Koppelfläche
- 37: Randbereich
- 38: elastischer Bereich
- 39: Wulst

- 40: Membranträger
- 41: Befestigungsbereich

- 50: z-Achse
- 51: erste Richtung
- 52: zweite Richtung

- 60: Stopper-Mechanismus
- 61: erster Anschlag
- 62: zweiter Anschlag

- 70: MEMS-Aktuator
- 71: Trägersubstrat
- 72: Stirnseite
- 73: Aktuatorstruktur
- 74: Koppelelement
- 81: Gehäuseteil
- 82: Vorsprung
- 83: Gehäuseteil
- 84: Leiterplatte
- 85: ASIC
- 86: Aussparung
- 87: erste Öffnung
- 88: zweite Öffnung
- 89: Gehäuseteil

- 92: Schallleitkanal
- 93: akustische Ein-/Austrittsöffnung

## Patentansprüche

1. MEMS-Schallwandler (2) zum Erzeugen und/oder Erfassen von Schallwellen im hörbaren Wellenlängenspektrum mit einem Membranträger (40),
einer Membran (30), die in ihrem Randbereich (37) mit dem Membranträger (40) verbunden ist und gegenüber dem Membranträger (40) entlang einer im Wesentlichen senkrecht zu der Membran (30) verlaufenden z-Achse (50) zu schwingen vermag,
einem MEMS-Aktuator (70), der mit der Membran (30) zusammenwirkt, und
einem Stopper-Mechanismus (60), der die Schwingungen der Membran (30) in zumindest einer Richtung (51) begrenzt, wobei der Stopper-Mechanismus (60) zumindest ein Verstärkungselement (31), das an einer Seite der Membran (30) angeordnet ist, und
einen dem Verstärkungselement (31) gegenüberliegenden Anschlag (61) aufweist, der in einer Neutralstellung der Membran (30) von dieser beabstandet ist und gegen den das Verstärkungselement (31) bei maximaler Auslenkung anstößt
**dadurch gekennzeichnet.**
**dass** der Anschlag (61) zumindest teilweise an einem Trägersubstrat (71) des MEMS-Aktuators (70) ausgebildet ist.

2. MEMS-Schallwandler nach dem vorherigen Anspruch, **dadurch gekennzeichnet, dass** das Verstärkungselement (31) an einer dem MEMS-Aktuator zugewandten Seite an der Membran (30) befestigt ist.

3. MEMS-Schallwandler nach einem oder mehreren der vorherigen Ansprüche, **dadurch gekennzeichnet, dass** die der Membran (30) zugewandte Stirnseite (72) des Trägersubstrates als Anschlag (61) ausgebildet ist und/oder
dass der MEMS-Aktuator (70) an einer der Membran (30) abgewandten Seite des Trägersubstrates eine Aktuatorstruktur (73) aufweist.

4. MEMS-Schallwandler nach einem oder mehreren der vorherigen Ansprüche, **dadurch gekennzeichnet, dass** der Randbereich der Membran (30) in einem vom MEMS-Aktuator (70) in z-Richtung beabstandeten Befestigungsbereich (41) des Membranträgers befestigt ist.

5. MEMS-Schallwandler nach einem oder mehreren der vorherigen Ansprüche, **dadurch gekennzeichnet, dass** zumindest ein Gehäuseteil (81, 83) und/oder die Leiterplatte (84) den Membranträger (40) bildet.

6. MEMS-Schallwandler nach einem oder mehreren der vorherigen Ansprüche, **dadurch gekennzeichnet, dass** die Membran (30) einen als Wulst (39) ausgebildeten, äußeren elastischen Bereich (38) und einen inneren verstärkten Bereich (32) aufweist, in dem das Verstärkungselement (31) angeordnet ist.

7. MEMS-Schallwandler nach dem vorherigen Anspruch 6, **dadurch gekennzeichnet, dass** das Verstärkungselement (31) benachbart zu dem elastischen Bereich (38) angeordnet ist.

8. MEMS-Schallwandler nach einem oder mehreren der vorherigen Ansprüche, **dadurch gekennzeichnet, dass** das Verstärkungselement (31) mit der Membran (30) verklebt ist.

9. MEMS-Schallwandler nach einem oder mehreren der vorherigen Ansprüche, **dadurch gekennzeichnet, dass** das Verstärkungselement (31) eine mit dem Anschlag korrespondierende Anschlagsfläche (33) aufweist.

10. MEMS-Schallwandler nach dem vorherigen Anspruch 9, **dadurch gekennzeichnet, dass** das Verstärkungselement (31) eine Koppelfläche (35) aufweist in deren Bereich das Verstärkungselement (31) mit der Aktuatorstruktur (73) mittelbar über ein Koppelelement (74) verbunden ist.

11. MEMS-Schallwandler nach dem vorherigen Anspruch 10, **dadurch gekennzeichnet, dass** die Anschlagsfläche (33) und die Koppelfläche (35) in z-Richtung voneinander beabstandet sind und über einen Zwischenbereich (34) des Verstärkungselementes miteinander verbunden sind.

12. MEMS-Schallwandler nach einem oder mehreren der vorherigen Ansprüche, **dadurch gekennzeichnet, dass** der Stopper-Mechanismus (60) einen zweiten Anschlag (62) umfasst, der die Schwingungen der Membran (30) entlang der z-Achse in einer zur ersten Richtung (51) entgegengesetzten zweiten Richtung (52) begrenzt.

13. MEMS-Schallwandler nach dem vorherigen Anspruch 12, **dadurch gekennzeichnet, dass** die beiden Anschläge (61, 62) zueinander gegenüberliegend angeordnet sind und
das Verstärkungselement (31) zwischen diesen beiden Anschlägen (61, 62) und von diesen beabstandet angeordnet ist.

14. Schallwandleranordnung (1) mit einem MEMS-Schallwandler (2) nach einem oder mehreren der vorherigen Ansprüche.

15. Schallwandleranordnung nach dem vorherigen Anspruch, **dadurch gekennzeichnet, dass** eine Leiterplatte (84) einen vollständig eingebetteten ASIC (85) und/oder eine sich durch diese erstreckende Aussparung (86) aufweist, wobei vorzugsweise an einer ersten Öffnung (87) der Aussparung ein MEMS-Aktuator (70) und/oder an einer zweiten Öffnung (88) der Aussparung zur Ausbildung einer geschlossenen Kavität (91) ein Gehäuseteil (89) angeordnet sind.

## Claims

1. MEMS sound transducer (2) for generating and/or detecting sound waves in the audible wavelength spectrum with a membrane carrier (40),
a membrane (30) that is connected in its edge area (37) to the membrane carrier (40), and may vibrate along a z-axis (50) substantially perpendicular to the membrane (30) with respect to the membrane carrier (40),
a MEMS actuator (70) interacting with the membrane (30), and
a stopper mechanism (60), which limits the vibrations of the membrane (30) in at least one direction (51),
wherein the stopper mechanism has at least one reinforcing element (31) that is arranged on one side of the membrane (30), and
an end stop (61) opposite to the reinforcing element (31), which, in a neutral position of the membrane (30), is spaced at a distance from it and against which the reinforcing element (31) abuts at a maximum deflection
**characterized in that**,
the end stop (61) is at least partially formed on carrier substrate (71) of the MEMS actuator (70).

2. MEMS sound transducer according to the preceding claim, **characterized in that** the reinforcing element (31) is fastened to the membrane (30) on a side turned towards the MEMS actuator.

3. MEMS sound transducer according to one or more of the preceding claims, **characterized in that** the front surface (72) of the carrier substrate turned towards the membrane (30) is formed as an end stop (61) and/or
that the MEMS actuator (70) features an actuator structure (73) on a side of the carrier substrate turned away from the membrane (30).

4. MEMS sound transducer according to one or more of the preceding claims, **characterized in that** the edge area of the membrane (30) is fastened in a fastening area (41) of the membrane carrier spaced at a distance from the MEMS actuator (70 in the z-direction.

5. MEMS sound transducer according to one or more of the preceding claims, **characterized in that** at least one housing part (81, 83) and/or the circuit board (84) forms the membrane carrier (40).

6. MEMS sound transducer according to one or more of the preceding claims, **characterized in that** the membrane (30) features an outer elastic area (38) formed as a bulge (39) and an inner reinforced area (32), in which the reinforcing element (31) is arranged.

7. MEMS sound transducer according to the preceding claim 6, **characterized in that** the reinforcing element (31) is arranged adjacent to the elastic area (38).

8. MEMS sound transducer according to one or more of the preceding claims, **characterized in that** the reinforcing element (31) is glued to the membrane (30).

9. MEMS sound transducer according to one or more of the preceding claims, **characterized in that** the reinforcing element (31) features an end stop surface (33) corresponding to the end stop.

10. MEMS sound transducer according to the preceding claim 9, **characterized in that** the reinforcing element (31) features a coupling surface, (35) in the area of which the reinforcing element (31) is connected indirectly through a coupling element (74) to the actuator structure (73).

11. MEMS sound transducer according to the preceding claim 10, **characterized in that** the end stop surface (33) and the coupling surface (35) are spaced at a distance from each other in the z-direction and are connected to each other through an intermediate area (34) of the reinforcing element.

12. MEMS sound transducer according to one or more of the preceding claims, **characterized in that** the stopper mechanism (60) comprises a second end stop (62), which limits the vibrations of the membrane (30) along the z-axis in a second direction (52) opposite to the first direction (51).

13. MEMS sound transducer according to the preceding claim 12, **characterized in that** the two end stops (61, 62) are arranged opposite to each other, and
the reinforcing element (31) is arranged between such end stops (61, 62) and is spaced at a distance from such end stops (61, 62).

14. Sound transducer arrangement (1) with a MEMS sound transducer (2) according to one or more of the preceding claims.

15. Sound transducer arrangement according to the preceding claim, **characterized in that** a circuit board (84) features a fully embedded ASIC (85) and/or a recess (86) extending through the circuit board (84), whereas, preferably, at a first opening (87) of the recess, a MEMS actuator (70) is arranged and/or, at a second opening (88) of the recess, a housing part (89) is arranged, in order to form a closed cavity (91).

## Revendications

1. Transducteur acoustique MEMS (2) pour générer et/ou détecter des ondes acoustiques dans le spectre de longueurs d'onde audible, avec un porte-membrane (40),
une membrane (30) qui est reliée dans sa zone de bordure (37) au porte-membrane (40) et qui est capable d'osciller par rapport au porte-membrane (40) le long d'un axe z (50) s'étendant sensiblement perpendiculairement à la membrane (30),
un actionneur MEMS (70) qui coopère avec la membrane (30), et
un mécanisme d'arrêt (60) qui limite les oscillations de la membrane (30) dans au moins une direction (51),
dans lequel le mécanisme d'arrêt (60) comprend au moins un élément de renforcement (31) qui est disposé sur un côté de la membrane (30), et
qui comporte une butée (61) qui est opposée à l'élément de renforcement (31), est espacée de la membrane (30) dans une position neutre de celle-ci et contre laquelle l'élément de renforcement (31) vient en butée à la déflexion maximale,
**caractérisé en ce que**
la butée (61) est formée au moins partiellement sur un substrat support (71) de l'actionneur MEMS (70).

2. Transducteur acoustique MEMS selon la revendication précédente, **caractérisé en ce que** l'élément de renforcement (31) est fixé sur la membrane (30) sur un côté de celle-ci faisant face à l'actionneur MEMS.

3. Transducteur acoustique MEMS selon l'une quelconque ou plusieurs des revendications précédentes, **caractérisé en ce que** la face frontale (72) du substrat support tournée vers la membrane (30) se présente sous la forme d'une butée (61) et/ou
**en ce que** l'actionneur MEMS (70) possède une structure d'actionneur (73) sur un côté du substrat support détourné de la membrane (30).

4. Transducteur acoustique MEMS selon l'une quelconque ou plusieurs des revendications précédentes, **caractérisé en ce que** la zone de bordure de la membrane (30) est fixée dans une zone de fixation (41) du porte-membrane espacée de l'actionneur MEMS (70) dans la direction z.

5. Transducteur acoustique MEMS selon l'une quelconque ou plusieurs des revendications précédentes, **caractérisé en ce qu'**au moins une partie de boîtier (81, 83) et/ou la carte imprimée (84) forme(nt) le porte-membrane (40).

6. Transducteur acoustique MEMS selon l'une quelconque ou plusieurs des revendications précédentes, **caractérisé en ce que** la membrane (30) comprend une région élastique extérieure (38) se présentant sous la forme d'un bourrelet (39) et une région renforcée intérieure (32) dans laquelle l'élément de renforcement (31) est disposé.

7. Transducteur acoustique MEMS selon la revendication 6 précédente, **caractérisé en ce que** l'élément de renforcement (31) est disposé à côté de la région élastique (38).

8. Transducteur acoustique MEMS selon l'une quelconque ou plusieurs des revendications précédentes, **caractérisé en ce que** l'élément de renforcement (31) est collé à la membrane (30).

9. Transducteur acoustique MEMS selon l'une quelconque ou plusieurs des revendications précédentes, **caractérisé en ce que** l'élément de renforcement (31) comprend une surface de butée (33) correspondant à la butée.

10. Transducteur acoustique MEMS selon la revendication 9 précédente, **caractérisé en ce que** l'élément de renforcement (31) présente une surface de couplage (35) dans la zone de laquelle l'élément de renforcement (31) est relié indirectement à la structure d'actionneur (73) par l'intermédiaire d'un élément de couplage (74).

11. Transducteur acoustique MEMS selon la revendication 10 précédente, **caractérisé en ce que** la surface de butée (33) et la surface de couplage (35) sont espacées l'une de l'autre dans la direction z et sont reliées l'une à l'autre par une région intermédiaire (34) de l'élément de renforcement.

12. Transducteur acoustique MEMS selon l'une quelconque ou plusieurs des revendications précédentes, **caractérisé en ce que** le mécanisme d'arrêt (60) comprend une deuxième butée (62) qui limite les oscillations de la membrane (30) le long de l'axe z dans une deuxième direction (52) opposée à la première direction (51).

13. Transducteur acoustique MEMS selon la revendication 12 précédente, **caractérisé en ce que** les deux butées (61, 62) sont disposées l'une en face de l'autre, et
l'élément de renforcement (31) est disposé entre ces deux butées (61, 62) et à distance de celles-ci.

14. Ensemble de transducteur acoustique (1) avec un transducteur acoustique MEMS (2) selon l'une quelconque ou plusieurs des revendications précédentes.

15. Ensemble de transducteur acoustique selon la revendication précédente, **caractérisé en ce qu'**une carte imprimée (84) comprend un ASIC (85) entièrement incorporé et/ou un évidement (86) s'étendant à travers celle-ci, sachant que, de préférence, un actionneur MEMS (70) est disposé à une première ouverture (87) de l'évidement et/ou une partie de boîtier (89) est disposée à une deuxième ouverture (88) de l'évidement pour former une cavité fermée (91).
